# EUROPÄISCHE PATENTSCHRIFT

(11) **EP 2 580 921 B1**
(45) Veröffentlichungstag und Bekanntmachung des Hinweises auf die Patenterteilung: **04.03.2015**
(21) Anmeldenummer: 11727136.1
(22) Anmeldetag: 26.05.2011
(51) Int. Cl.: H04Q 9/00, G01R 31/317, G06F 1/26, G01R 31/319

(54) **MESSGERÄT UND MESSSYSTEM**
MEASURING DEVICE AND MEASUREMENT SYSTEM
APPAREIL DE MESURE ET SYSTÈME DE MESURE

(30) Priorität: 10.06.2010 DE 102010029906
(43) Veröffentlichungstag der Anmeldung: 17.04.2013
(73) Patentinhaber: BSH Bosch und Siemens Hausgeräte GmbH, 81739 München (DE)
(72) Erfinder: THUILLE, Wolfgang, 81929 Muenchen (DE)
(86) Internationale Anmeldenummer: PCT/EP2011/058645
(87) Internationale Veröffentlichungsnummer: WO 2011/154266

(56) Entgegenhaltungen:
- EP-A2- 0 470 402
- DE-U1-202009 010 988
- US-A1- 2007 047 212
- US-A1- 2008 174 318
- US-A1- 2009 049 352

## Beschreibung

Die Erfindung betrifft ein Messgerät zum Überprüfen eines elektrischen Gerätes und ein Messsystem mit einem solchen Messgerät.

Die Durchführung von Funktionsprüfungen oder Sicherheitsüberprüfungen eines elektrischen Gerätes z.B. nach VDE 0701 kann beispielsweise im Rahmen von Reparaturaufträgen erforderlich sein. Sicherheitsüberprüfungen z.B. nach VDE 0701 oder Funktionsüberprüfungen können mit manuellen Einzelgeräten durchgeführt werden. Sicherheitstechnisch sensible Messwerte werden in der Regel von Hand von einem Display abgeschrieben, um gegebenenfalls einer Dokumentationspflicht zu genügen.

Die Patentschrift US 2007/047 212 offenbart ein Messgerät zum Testen von elektronischen oder integrierten Schaltungen.

Aufgabe der Erfindung ist es, ein verbessertes Messgerät zum Überprüfen eines elektrischen Gerätes anzugeben.

Unter einem elektrischen Gerät wird insbesondere ein elektrisches Haushaltsgerät verstanden, also ein Gerät, das zur Haushaltsführung eingesetzt wird. Das kann ein Haushaltsgroßgerät sein, wie beispielsweise eine Waschmaschine, ein Wäschetrockner, eine Geschirrspülmaschine, ein Gargerät, eine Dunstabzugshaube oder ein Kältegerät. Das kann aber auch ein Haushaltskleingerät sein, wie beispielsweise ein Warmwasserbereiter oder ein Kaffeevollautomat.

Die Aufgabe der Erfindung wird gelöst durch ein Messgerät zum Überprüfen eines elektrischen Gerätes, aufweisend ein Basisgerät, ein Gehäuse, eine am Gehäuse angeordnete Steckdose, die vorgesehen ist, dass über diese das elektrische Gerät während der Überprüfung mit dem Basisgerät verbunden ist und mit elektrischer Energie versorgt wird, eine innerhalb des Gehäuses angeordnete Messelektronik und eine am Gehäuse angeordnete elektronische Schnittstelle zum Verbinden des Basisgerätes mit einem Rechner, sowie wenigstens ein mit dem Basisgerät koppelbares Funktionsmodul zum modularen Erweitern des Messgerätes. Das elektrische Gerät ist insbesondere ein Haushaltsgerät.

Das erfindungsgemäße Messgerät umfasst demnach das Basisgerät, welches als solches insbesondere in Kombination mit dem Rechner zum Überprüfen des elektrischen Gerätes insbesondere im Rahmen einer Sicherheits- oder einer Funktionsüberprüfung verwendet werden kann. Im Rahmen dieser Überprüfung ist das elektrische Gerät mit seinem Netzstecker mit der Steckdose des Basisgeräts verbunden und wird für die Überprüfung über das Basisgerät mit elektrischer Energie versorgt. Das Basisgerät umfasst einen Netzanschluss, z.B. ein Netzkabel, um beispielsweise am örtlichen Stromnetz angeschlossen zu werden. Erfindungsgemäß ist das Messgerät modular aufgebaut, sodass das Basisgerät mit wenigstens einem Funktionsmodul erweiterbar ist. Dadurch ist es in relativ einfacher Weise möglich, den Funktionsbereich des Basisgerätes zu erweitern.

Das Basisgerät kann vorzugsweise derart ausgeführt sein, dass während der Überprüfung der Rechner mit der Schnittstelle des Basisgerätes verbunden ist, um mittels einer bidirektionalen Kommunikation die Messelektronik für die Überprüfung anzusteuern und/oder mittels des Messgerätes ermittelte Messergebnisse auszulesen. Dadurch ist es u.A. möglich, das Basisgerät ohne einer integrierten Anzeigevorrichtung auszuführen und gegebenenfalls mittels des Messgerätes ermittelte Messwerte auf einer mit dem Rechner verbundenen oder in den Rechner integrierten Anzeigevorrichtung visuell anzuzeigen.

Ein weiterer Aspekt der Erfindung betrifft ein Messsystem, aufweisend das erfindungsgemäße Messgerät und einen mit dem Basisgerät des Messgerätes über dessen elektronische Schnittstelle gekoppelten Rechner, der mittels einer bidirektionalen Kommunikation die Messelektronik des Basisgerätes für die Messung ansteuert und/oder mittels des Messgerätes ermittelte Messergebnisse ausliest. Der Rechner ist vorzugsweise eingerichtet, mittels des Messgerätes ermittelter Messwerte auf einer mit dem Rechner verbundenen oder in den Rechner integrierten Anzeigevorrichtung visuell anzuzeigen. Somit kann das Basisgerät ohne einer Anzeige ausgeführt werden, wodurch dieses beispielsweise kompakter oder einfacher ausgeführt werden kann. Auch ist es in relativ einfacher Weise möglich, Anzeigemöglichkeiten dem individuellen elektrischen Gerät, welches mittels des erfindungsgemäßen Messgerätes überprüft wird, anzupassen.

Die Schnittstelle des Basisgerätes ist gemäß einer Variante des erfindungsgemäßen Messgerätes als eine USB-Device Schnittstelle ausgeführt. USB ist ein serieller Bus, bei dem die einzelnen Bits eines Datenpaketes nacheinander übertragen werden. Die Datenübertragung erfolgt vorzugsweise symmetrisch insbesondere über zwei verdrillte Leitungen. Die USB-Spezifikation sieht einen zentralen Host-Controller, auch als Master bezeichnet, vor, der die Koordination der angeschlossenen Peripherie-Geräte übernimmt. Diese weise einen USB-Device Schnittstelle auf.

Um das Funktionsmodul oder die Funktionsmodule am Basisgerät elektrisch anzuschließen, kann das erfindungsgemäße Messgerät ein USB-Hub-Modul mit einer USB-Schnittstelle zum Verbinden des USB-Hub-Moduls mit der USB-Device Schnittstelle des Basisgerätes umfassen, wobei das USB-Hub-Modul wenigstens zwei weitere USB-Schnittstellen aufweist, von denen eine vorgesehen ist, während der bidirektionalen Kommunikation mit dem Rechner verbunden zu sein, und die andere vorgesehen ist, mit dem Funktionsmodul verbindbar zu sein. Somit ist es möglich, dass das Basisgerät nur eine USB-Device Schnittstelle umfasst und gegebenenfalls mittels des USB-Hub-Moduls derart erweiterbar ist, dass wenigstens ein Funktionsmodul, das vorzugsweise ebenfalls eine USB-Device-Schnittstelle umfasst, am Basisgerät angeschlossen werden kann.

Um das Funktionsmodul beispielsweise relativ klein ausführen zu können, sodass es z.B. keine eigene Stromversorgung benötigt, kann es vorgesehen sein, dass das Funktionsmodul über das USB-Hub-Modul von dem Basisgerät mit elektrischer Energie versorgbar ist.

Nach einer bevorzugten Ausführungsform des erfindungsgemäßen Messgerätes ist das Funktionsmodul auch ohne mit dem Basisgerät gekoppelt zu sein individuell betreibbar. Dies erhöht die Anwendbarkeit des Funktionsmoduls, da es auch getrennt vom Basisgerät betrieben werden kann.

Um eine drahtlose Kommunikation zwischen dem Basisgerät und dem Rechner zu ermöglichen, kann das erfindungsgemäße Messgerät ein mit der Schnittstelle des Basisgerätes koppelbares Sende-/Empfangsmodul für eine drahtlose bidirektionale Kommunikation zwischen dem Rechner und dem Basisgerät umfassen. Dieses kann über das USB-Hub-Modul mit der USB-Device Schnittstelle des Basisgerätes verbunden werden. Das Sende-/Empfangsmodul kann als ein Funktionsmodul ausgeführt sein.

Das Sende-/Empfangsmodul kann eine Anzeige zum Anzeigen von mit dem Messgerät ermittelter Messwerte umfassen.

Um das erfindungsgemäße Messgerät flexibler einsetzen zu können, kann die am Gehäuse des Basisgeräts angeordnete Steckdose lösbar am Gehäuse befestigt sein und durch eine weitere, am Gehäuse des Basisgerätes lösbar befestigbare Steckdose austauschbar sein. Dann kann das Basisgerät bzw. das erfindungsgemäße Messgerät in verschieden Ländern eingesetzt werden. Der Netzstecker des Basisgerätes kann ebenfalls austauschbar sein, um das Basisgerät an verschiedene Stromnetze anschließen zu können.

Um den Einsatzbereich des erfindungsgemäßen Messgerätes zu erhöhen, kann das Basisgerät einen Anschluss zum Anschließen einer Ableitstromzange und/oder einen Anschluss zum Beaufschlagen des zu überprüfenden Gerätes mit einer Prüfspannung von vorzugsweise 500V Gleichspannung umfassen.

Der Rechner, mit dem das Basisgerät des erfindungsgemäßen Messgerätes kommunizieren kann, kann z.B. als ein PC ausgeführt sein. Der Rechner kann aber auch als ein PDA oder ein Smartphone ausgeführt sein.

Das erfindungsgemäße Messgerät umfasst demnach eine modular aufgebaute Hardware, die insbesondere dazu geeignet ist, alle Sicherheitsüberprüfungen vorzugsweise nach VDE 0701 durchzuführen. Diese Hardware ist vorzugsweise durch Stecktechnik modular erweiterbar beispielsweise für Funktionsmessungen, in der Art, dass z.B. ein als Digitalmultimer-Modul ausgeführtes Funktionsmodul angebracht werden kann.

Um das zu überprüfende elektrische Gerät, das z.B. ein Hausgerät ist, z.B. mit den Messabläufen von Sicherheits- und Funktionstests zu synchronisieren, ist die elektronische Schnittstelle vorgesehen. Dadurch entsteht eine Einheit, die über eine einzige USB-Schnittstelle mit dem Host-USB-Anschluss des Rechners z.B. des Anwenders verbunden wird. Hierbei übernimmt vorzugsweise der Rechner bidirektional sowohl die Ansteuerung der messtechnischen Hardware (Setzen der Messbereiche), als auch das Auslesen der Messergebnisse. Dadurch können kostspielige Anzeigen und Bedienelemente direkt an der Hardware (Basisgerät) entfallen. Dadurch ist es möglich, dass die Gesamtkosten des erfindungsgemäßen Messgerätes bzw. Messsystems unter die Summe der Preise von einzelnen konventionellen Messgeräten fallen.

Anstatt eines USB-Kabels verfügt das erfindungsgemäße Messgerät vorzugsweise zudem über einen Steckplatz für das gegebenenfalls vorhandene USB-Hub-Modul (USB-Device-Bridge), mit deren Hilfe z.B. ein PDA oder ein Smartphone, das lediglich über eine USB-Device-Schnittstelle verfügt, ebenfalls zur Ansteuerung und zum Auslesen genutzt werden kann.

Anstatt der USB-Device-Bridge kann das Sende-/Empfangsmodul, das insbesondere als ein Bluetooth/Anzeigemodul ausgeführt sein kann, am Basisgerät angesteckt werden, das optional für eine drahtlose Kommunikation mit Computern, PDAs und Smartphones sorgt und vorzugsweise über ein eingebautes Einfach-Display die aktuellen Messwerte direkt zur Kontrolle anzeigen kann.

Besondere Eigenschaften des erfindungsgemäßen Messgerätes können je nach Ausführungsform sein:

Das erfindungsgemäße Messgerät kann vollständig international einsetzbar ausgeführt sein, indem z.B. austauschbare Prüfdosen (Steckdosen) und Netzzuleitungen zum Einsatz kommen. Beispielsweise über eine BNC-Buchse können hochqualitative Ableitstrommessungen durchgeführt werden, indem gegebenenfalls die dem Messgerät zugehörige Ableitstromzange zum Einsatz kommt. Damit ist die qualifizierte Überprüfung und Dokumentation fest angeschlossener Geräte mit hoher Leistungsaufnahme möglich. Ein eventuell vorhandenes weiteres Buchsenpaar am Basisgerät kann die Überprüfung von einzelnen Bauelementen bei einer Prüfspannung von z.B. 500 V DC erlauben, um z.B. die Güte der Isolation sicherstellen zu können.

Umpolung des Prüflings, d.h. des zu überprüfenden Gerätes, und FI-Funktionen können bereits im Basisgerät integriert sein. Die Sicherheit der Stromversorgung im Haushalt kann z.B. durch zwei getrennte Tests garantiert werden, die in der Regel im Vorfeld aller anderen Tests ablaufen. Dabei ist keine funktionierende Spannungsversorgung erforderlich.

Die Steuerung aller Messfunktionen erfolgt vorzugsweise durch ein vorhandene Software in einem speziellen Funktionsmenü, welches z.B. in der Optik analoger Messinstrumente spezifische automatische Messabläufe und spezifisch eingeschränkte Funktionsumfänge je nach Prüfling zur Verfügung stellt. Diese Spezifika können von den Herstellerwerken der jeweiligen Hausgeräte optional durch einfach aufgebaute Textdateien festgelegt werden. Dann stehen ohne weitere Festlegungen der volle Funktionsumfang und keine automatische Abläufe zur Verfügung. Die Dokumentation aller Messergebnisse kann in einer Log-Datei, die z.B. angezeigt, ausgedruckt und abgespeichert werden kann, und bei Anwendung in eine zentrale Datenbank übergeben werden kann, welche dann die Daten über ein Qualitätsbeurteilungs-Tool z.B. an die Qualitätsabteilungen der Herstellerwerke zurückmelden kann.

Vorteile des erfindungsgemäßen Messgerätes oder des erfindungsgemäßen Messsystems können je nach Ausführungsform sein:
- Kostengünstiger als einzelne Messgeräte,
- durchgängige und nachhaltige Dokumentierbarkeit und Nachverfolgbarkeit der Messwerte bis auf den einzelnen Reparaturjob zurück,
- modulare Konfigurierbarkeit je nach Anforderungsprofil des Anwenders,
- Flexibilität der Schnittstellen (USB Host, USB Device, Bluetooth) und Stromanschlüsse,
- Einsatz vorhandener Ansteuersoftware mit integrierter grafischer Bedien-Hilfe Individualisierbarkeit und Automatisierbarkeit von Messabläufen sorgt für kompetentere Messungen mit abgesicherten Ergebnissen.

Ein Ausführungsbeispiel der Erfindung ist exemplarisch in den beigefügten schematischen Zeichnungen dargestellt. Es zeigen:
- Fig. 1: eine Seitenansicht eines Messsystems, das ein Messgerät und einen mit einem Basisgerät des Messgerätes verbundenen Rechner aufweist,
- Fig. 2: ein die Systemarchitektur des Messgerätes veranschaulichendes Diagramm,
- Fig. 3: eine Draufsicht des Basisgerätes,
- Fig. 4: eine Draufsicht des Basisgerätes, das mit einem USB-Hub-Modul versehen ist,
- Fig. 5: eine Draufsicht des Basisgerätes, das mit dem USB-Hub-Modul und einem am USB-Hub-Modul angeschlossenen Funktionsmodul versehen ist,
- Fig. 6: eine Draufsicht des Basisgerätes, das mit dem USB-Hub-Modul und zwei am USB-Hub-Modul angeschlossene Funktionsmodule versehen ist,
- Fig. 7: eine Anzeige der Anzeigevorrichtung des Rechners der Figur 1 und
- Fig. 8: eine weitere Anzeige der Anzeigevorrichtung und ein auf der Anzeigevorrichtung angezeigtes Diagramm.

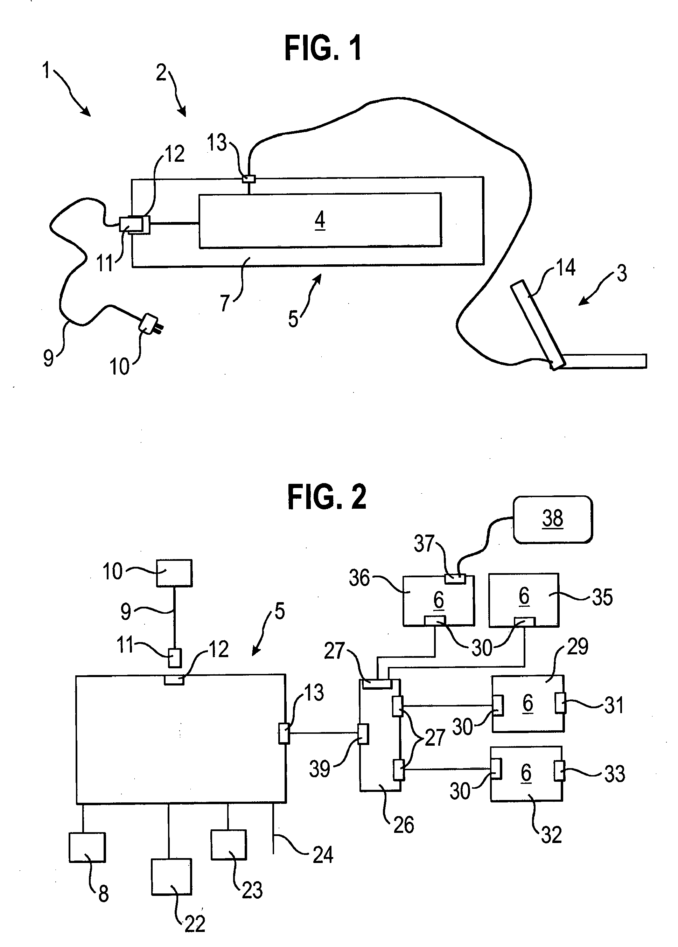

Die Fig. 1 zeigt eine Seitenansicht eines Messsystems 1, das ein Messgerät 2 und einen mit dem Messgerät 2 verbundenen Rechner 3 umfasst. Der Rechner 3 ist z.B. ein PC, insbesondere ein Laptop, kann aber auch ein PDA oder ein Smartphone sein. Die Fig. 2 zeigt ein die Systemarchitektur des Messgerätes 2 veranschaulichendes Diagramm.

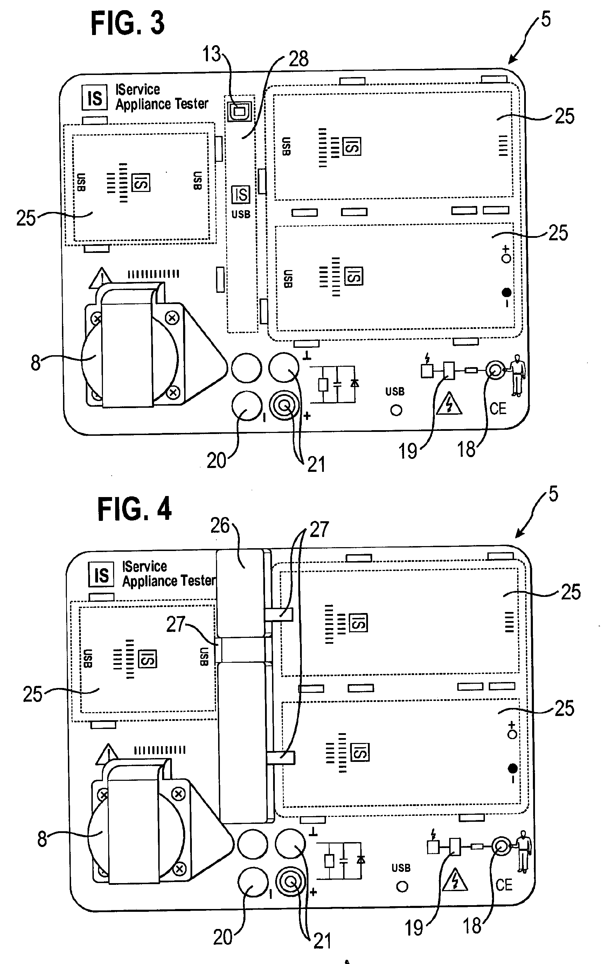

Das Messgerät 2 weist ein Basisgerät 5 auf, dessen Draufsicht in der Fig. 3 gezeigt ist. Das Messgerät 2 kann mit wenigstens einem in den Figuren 2, 5 und 6 dargestellten Funktionsmodul 6 erweitert werden. Das Basisgerät 5 ist jedoch derart ausgeführt, dass mit ihm alleine, bzw. mit ihm alleine und einem angeschlossenen Rechner eine Grundüberprüfung eines nicht näher dargestellten elektrischen Gerätes, z.B. einem Haushaltsgerät, durchgeführt werden kann.

Das Basisgerät 5 weist ein Gehäuse 7 auf, in dessen Innerem eine Messelektronik 4 des Messgerätes 2 angeordnet ist. Das Basisgerät 5 umfasst ferner eine Steckdose 8, an der das zu überprüfende Gerät mit seinem Netzanschluss während der Überprüfung angeschlossen ist und mit elektrischer Energie versorgt wird. Die Steckdose 8 ist am Gehäuse 7 angeordnet und im Falle des vorliegenden Ausführungsbeispiels lösbar am Basisgerät 5 befestigt, sodass die Steckdose 8 vom Basisgerät 5 entfernt und durch eine andere Steckdose ersetzt werden kann. Somit ist es möglich, dass mit dem Basisgerät 5 und somit mit dem Messgerät 2 bzw. dem Messsystem 1 elektrische Geräte in verschiedenen Ländern geprüft werden können. Die Steckdose 8 stellt somit im Falle des vorliegenden Ausführungsbeispiels eine modular tauschbare Netzsteckdose für den Prüfling bzw. das zu überprüfende Gerät dar.

Das Basisgerät 5 umfasst ferner einen Netzanschluss in Form eines Netzkabels 9, an dessen einem Ende ein Netzstecker 10 angeordnet ist. Am anderen Ende des Netzkabels 9 ist ein Stecker 11 angeordnet, der in einen am Gehäuse 7 befestigten Gegenstecker 12 gesteckt werden kann. Die den Stecker 11 und den Gegenstecker 12 bildende Steckverbindung ist z.B. eine 20 A-Kaltgeräte Steckverbindung. Das Netzkabel 9 kann daher im Falle des vorliegenden Ausführungsbeispiels an das Basisgerät 5 gesteckt und somit durch ein anderes Netzkabel ersetzt werden, wodurch dass Basisgerät 5 und somit das Messgerät 2 in verschiedenen Ländern einsetzbar ist.

Das Basisgerät 5 weist eine elektronische Schnittstelle auf, über die das Basisgerät 5 mit dem Rechner 3 kommunizieren kann. Die Schnittstelle ist im Falle des vorliegenden Ausführungsbeispiels als eine USB-Device Schnittstelle 13 ausgeführt. Außerdem umfasst im Falle des vorliegenden Ausführungsbeispiels das Basisgerät 5 genau eine USB-Device Schnittstelle 13.

Das Basisgerät 5 ist derart ausgeführt, dass allein mit ihm in Verbindung mit dem Rechner 3 eine Basisprüfung des zu überprüfenden Gerätes durchgeführt werden kann. Diese Basisprüfung ist im Falle des vorliegenden Ausführungsbeispiels eine Sicherheitsprüfung nach VDE. Für die Prüfung kommuniziert der Rechner 3 über die USB-Device Schnittstelle 13 mit dem Basisgerät 5 bidirektional. Hierbei übernimmt vorzugsweise der Rechner 3 bidirektional sowohl die Ansteuerung der Messelektronik 4, wie z.B. Setzen der Messbereiche, als auch das Auslesen der Messergebnisse. Dadurch können kostspielige Anzeigen und Bedienelemente direkt am Basisgerät 5 entfallen und die Messwerte können am Bildschirm 14 des Rechners 3 dargestellt werden.

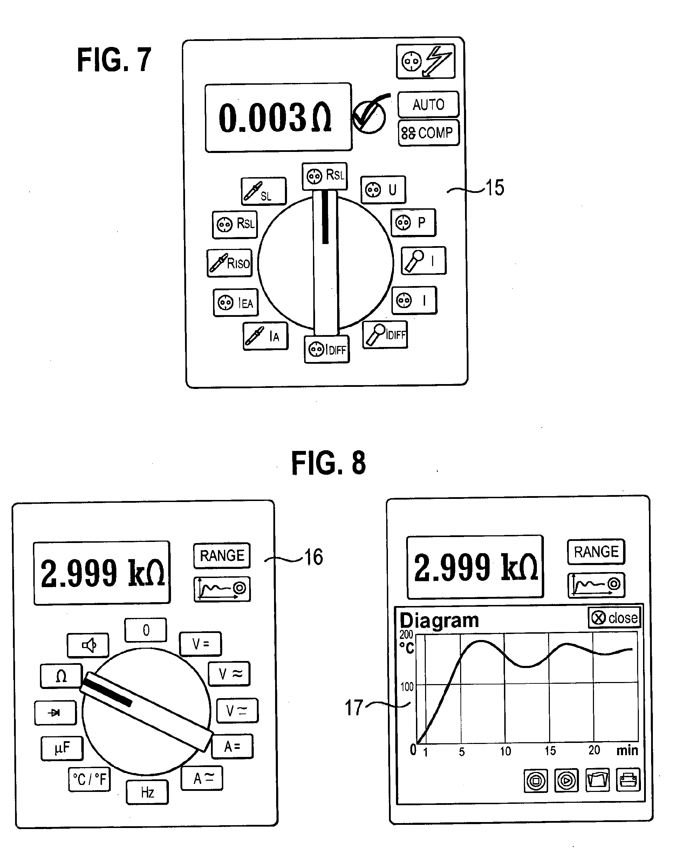

Im Falle des vorliegenden Ausführungsbeispiels läuft auf dem Rechner 3 ein Rechenprogramm, das für die Überprüfung des Gerätes nötige Einstellungen steuert. So kann z.B. auf dem Bildschirm 14 visuell einem Benutzer mehrere Möglichkeiten einer durchzuführenden Messung angezeigt werden. Je nach gewählter Messung kann dann auf dem Bildschirm 14 eine in der Fig. 7 gezeigte Darstellung 15 angezeigt werden, die ein der gewählten Messung entsprechendes Messinstrument darstellt. Auch können auf dem Bildschirm 14 Hinweise auf die Durchführung der gewählten Messung angezeigt werden. Wird eine alternative Messung gewählt, dann kann eine in der Fig. 8 gezeigte Darstellung 16 am Bildschirm 14 angezeigt werden. Messergebisse dieser Messung können mittels eines in der Fig. 8 gezeigten Diagramms 17 visualisiert werden.

Im Falle des vorliegenden Ausführungsbeispiels weist das Basisgerät 5 eine Berührfläche 18 auf, die vorgesehen ist, dass sie von einem Benutzer des Basisgerätes 5 für einen Nachweis des Netzpotenzials auf einer Schutzleitklemme des zu überprüfenden Gerätes berührt wird. Das Ergebnis wird z.B. mittels eines LCD-Balkens 19 des Basisgerätes 5 dem Benutzer angezeigt.

Das Basisgerät 5 umfasst im Falle des vorliegenden Ausführungsbeispiels genau eine Steckdose 8 insbesondere zum Messen und Betreiben des zu überprüfenden Gerätes. Es kann auch eine Warnlampe 20 vorgesehen sein, die aufleuchtet, wenn das zu überprüfende Gerät über die Steckdose 8 mit Netzspannung gespeist wird. Die Steckdose 8 kann auch derart eingerichtet sein, dass das Basisgerät 5, wenn z.B. erforderlich, den Neutralleiter und den Außenleiter der Steckdose 8 umpolt.

Im Falle des vorliegenden Ausführungsbeispiels umfasst das Basisgerät 5 Messbuchsen 21 beispielsweise zum Anschluss einer Sonde 23, Zange oder für einen Bauteiltest mit Hochspannung 24. Die Messbuchsen 21 sind z.B. klar beschriftet. Die Zange ist z.B. eine Differenzstromzange oder eine System-Leckstromzange 22. Die Sonde 23 ist z.B. eine Bürstensonde, die Brandflecken durch Stromstoss auf empfindlichen Flächen vermeidet.

Wie bereits erwähnt, kann das Messgerät 2 bzw. das Basisgerät 5 durch Funktionsmodule 6 erweitert werden. Zur Aufnahme der Funktionsmodule 6 umfasst im Falle des vorliegenden Ausführungsbeispiels das Basisgerät 5 Steckplätze 25.

Im Falle des vorliegenden Ausführungsbeispiels kommunizieren die Funktionsmodule 6 über USB-Device Schnittstellen 30 mit dem Basisgerät 5. Dieses umfasst im Falle des vorliegenden Ausführungsbeispiels jedoch nur die einzige USB-Device Schnittstelle 13. Damit die Funktionsmodule 6 angeschlossen werden können, ist ein USB-Hub Modul 26 vorgesehen, das z.B. am Gehäuse 7 des Basisgeräts 5 auf einem Steckplatz 28 lösbar befestigt werden kann. Das Basisgerät 5 mit aufgesetztem USB-Hub Modul 26 bzw. Gateway ist z.B. in der Fig. 4 gezeigt.

Das USB-Hub Modul 26 umfasst im Falle des vorliegenden Ausführungsbeispiels eine USB-Device Schnittstelle 39, die in die USB-Device Schnittstelle 13 des Basisgerätes 5 gesteckt werden kann. Das USB-Hub Modul 26 umfasst ferner drei weitere USB-Device Schnittstellen 27, die vorgesehen sind, mit jeweils einem Funktionsmodul 6 verbunden zu werden. Eine weitere der USB-Device Schnittstellen 27 des USB-Hub Moduls 26 kann auch vorgesehen sein, mit dem Rechner 3 verbunden zu werden.

Im Falle des vorliegenden Ausführungsbeispiels ist das USB-Hub Modul 26 derart ausgeführt, dass die Funktionsmodule 6 über die Schnittstellen 27 und der Schnittstelle 39 vom Basisgerät 5 mit elektrischer Energie versorgt zu werden.

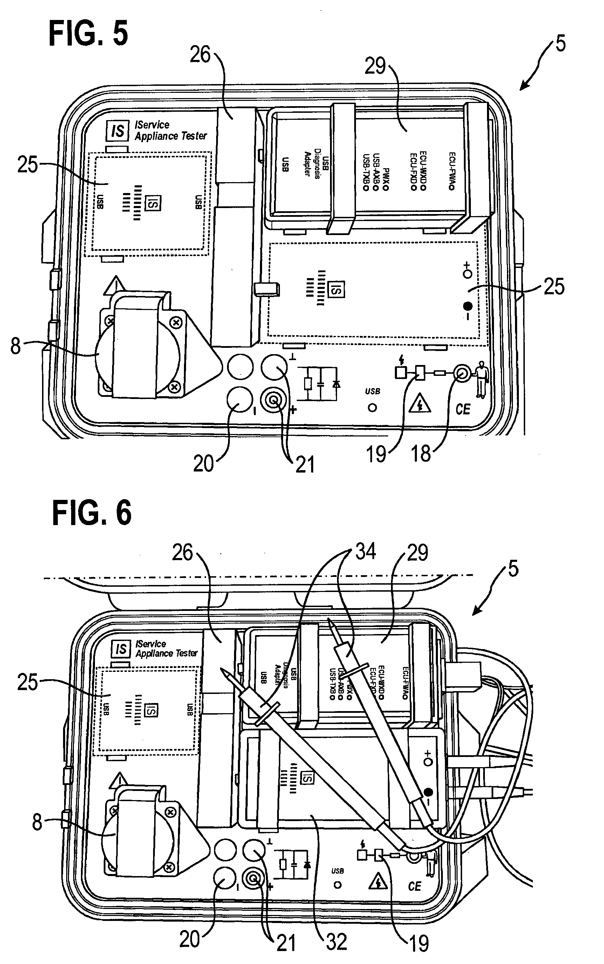

Bei den Funktionsmodulen 6 kann es sich z.B. um ein in den Figuren 5, 6 gezeigtes Modul 29 handeln, welches einerseits mit seiner USB-Device Schnittstelle 30 mit einem der USB-Device Schnittstellen 27 des USB-Hub Moduls 26 verbunden ist, und eine vom USB Standard verschiedene Schnittstelle 31 umfasst. Das Modul 29 ist derart eingerichtet, dass es eine Konvertierung von Daten gemäß dem USB-Standard in Daten gemäß dem Standard der Schnittstelle 31 und umgekehrt durchführt. Das Modul 29 kann z.B. für eine Fehlerdiagnose des zu überprüfenden Gerätes oder für ein so genanntes Flashing vorgesehen sein.

Bei den Funktionsmodulen 6 kann es sich z.B. auch um ein in der Fig. 6 gezeigtes Multimetermodul 32 handeln, welches einerseits mit seiner USB-Device Schnittstelle 30 mit einem der USB-Device Schnittstellen 27 des USB-Hub Moduls 26 verbunden ist, und eine weitere Schnittstelle 33 umfasst, an die beispielsweise Messproben 34 angesteckt werden können. Mit dem Multimetermodul 32 können z.B. Multimetermessungen durchgeführt und/oder Temperaturkennlinien aufgenommen werden.

Wie bereits beschrieben, ist eine der USB-Schnittstellen 27 des USB-Hub Moduls 26 für die Verbindung mit dem Rechner 3 vorgesehen. Um eine drahtlose Verbindung mit dem Rechner 3 zu ermöglichen, kann das Funktionsmodul 6 auch als ein Sende-/Empfangsmodul 35 ausgeführt sein, das mit seiner USB-Device Schnittstelle 30 mit einem der USB-Schnittstellen 27 des USB-Hub Moduls 26 oder mit der USB-Device Schnittstelle 13 des Basisgerätes 5 verbunden werden kann. Das Sende-/Empfangsmodul 35 kann insbesondere derart ausgeführt sein, dass es eine drahtlose bidirektionale Kommunikation zwischen dem Rechner 3 und dem Basisgerät 5 mittels Bluetooth erlaubt. Das Sende-/Empfangsmodul 35 kann auch eine Anzeige zum Anzeigen von mit dem Messgerät 2 ermittelter Messwerte umfassen.

Um z.B. eine Kommunikation zwischen dem Basisgerät 5 und einem PDA 38 oder einem Smartphone zu ermöglichen, die ebenfalls nur über eine USB-Device Schnittstelle, also keine USB-Host Schnittstelle aufweisen, wie dies bei einem PC oder Laptop der Fall ist, kann das Funktionsmodul 6 auch als ein Umsetzungsmodul 36 ausgeführt sein, welches derart ausgeführt ist, dass es in Verbindung mit einem an einer USB-Schnittstelle 37 des Umsetzungsmodul 36 angeschlossenen PDA 38 oder Smartphone einen USB-Host simuliert.

Im Falle des vorliegenden Ausführungsbeispiels können die Funktionsmodule auch ohne am Basisgerät 5 angeschlossen zu sein betrieben werden.

### BEZUGSZEICHENLISTE

- 1: Messsystem
- 2: Messgerät
- 3: Rechner
- 4: Messelektronik
- 5: Basisgerät
- 6: Funktionsmodul
- 7: Gehäuse
- 8: Steckdose
- 9: Netzkabel
- 10: Netzstecker
- 11: Stecker
- 12: Gegenstecker
- 13: USB-Device Schnittstelle
- 14: Bildschirm
- 15, 16: Darstellung
- 17: Diagramms
- 18: Berührfläche
- 19: LCD-Balken
- 20: Warnlampe
- 21: Messbuchsen
- 22: System-Leckstromzange
- 23: Sonde
- 24: Hochspannung
- 25: Steckplätze
- 26: USB-Hub Modul
- 27: USB-Device Schnittstellen
- 28: Steckplatz
- 29: Modul
- 30: USB-Device Schnittstelle
- 31: Schnittstelle
- 32: Multimetermodul
- 33: Schnittstelle
- 34: Messproben
- 35: Sende-/Empfangsmodul
- 36: Umsetzungsmodul
- 37: USB-Schnittstelle
- 38: PDA
- 39: USB-Device Schnittstelle

## Patentansprüche

1. Messgerät zum Überprüfen eines elektrischen Gerätes, aufweisend ein Basisgerät (5), ein Gehäuse (7), eine am Gehäuse (7) angeordnete Steckdose (8), die vorgesehen ist, dass über diese das elektrische Gerät während der Überprüfung mit dem Basisgerät (5) verbunden ist und mit elektrischer Energie versorgt wird, eine innerhalb des Gehäuses (7) angeordnete Messelektronik (4) und eine am Gehäuse (7) angeordnete elektronische Schnittstelle (13) zum Verbinden des Basisgerätes (5) mit einem Rechner (3, 38), sowie wenigstens ein mit dem Basisgerät (5) koppelbares Funktionsmodul (6) zum modularen Erweitern des Messgerätes (2).

2. Messgerät nach Anspruch 1, **dadurch gekennzeichnet, dass** das Basisgerät (5) derart ausgeführt ist, dass während der Überprüfung der Rechner (3, 38) mit der Schnittstelle (13) des Basisgerätes (5) verbunden ist, um mittels einer bidirektionalen Kommunikation die Messelektronik (4) für die Überprüfung anzusteuern und/oder mittels des Messgerätes (2) ermittelte Messergebnisse auszulesen.

3. Messgerät nach Anspruch 2, **dadurch gekennzeichnet, dass** das Basisgerät (5) ohne einer integrierten Anzeigevorrichtung ausgeführt ist.

4. Messgerät nach einem der Ansprüche 1 bis 3, **dadurch gekennzeichnet, dass** die Schnittstelle des Basisgerätes (5) als eine USB-Device Schnittstelle (13) ausgeführt ist.

5. Messgerät nach Anspruch 4, **gekennzeichnet durch** ein USB-Hub-Modul (26) mit einer USB-Schnittstelle (39) zum Verbinden des USB-Hub-Moduls (26) mit der USB-Device Schnittstelle (13) des Basisgerätes, wobei das USB-Hub-Modul (26) wenigstens zwei weitere USB-Schnittstellen (27) aufweist, von denen eine vorgesehen ist, während der bidirektionalen Kommunikation mit dem Rechner (3) verbunden zu sein, und die andere vorgesehen ist, mit dem Funktionsmodul (6) verbindbar zu sein.

6. Messgerät nach Anspruch 5, **dadurch gekennzeichnet, dass** das Funktionsmodul (6) über das USB-Hub-Modul (26) von dem Basisgerät (5) mit elektrischer Energie versorgbar ist.

7. Messgerät nach einem der Ansprüche 1 bis 6, **dadurch gekennzeichnet, dass** das Funktionsmodul (6) auch ohne mit dem Basisgerät gekoppelt zu sein individuell betreibbar ist.

8. Messgerät nach einem der Ansprüche 2 bis 7, **gekennzeichnet durch** ein mit der Schnittstelle (13) des Basisgerätes (5) koppelbares Sende-/Empfangsmodul (35) für eine drahtlose bidirektionale Kommunikation zwischen dem Rechner und dem Basisgerät (5).

9. Messgerät nach Anspruch 8, **dadurch gekennzeichnet, dass** das Sende-/Empfangsmodul (35) eine Anzeige zum Anzeigen von mit dem Messgerät (2) ermittelter Messwerte umfasst.

10. Messgerät nach einem der Ansprüche 1 bis 9, **dadurch gekennzeichnet, dass** die am Gehäuse (7) des Basisgerät (5) angeordnete Steckdose (8) lösbar am Gehäuse (7) befestigt ist und durch eine weitere, am Gehäuse (7) des Basisgerätes (5) lösbar befestigbare Steckdose austauschbar ist.

11. Messgerät nach einem der Ansprüche 1 bis 10, **dadurch gekennzeichnet, dass** das Basisgerät (5) einen Anschluss zum Anschließen einer Ableitstromzange (22) umfasst und/oder das Basisgerät (5) einen Anschluss zum Beaufschlagen des zu überprüfenden Gerätes mit einer Prüfspannung von vorzugsweise 500V Gleichspannung umfasst.

12. Messsystem, aufweisend ein Messgerät (2) nach einem der Ansprüche 2 bis 11 und einen mit dem Basisgerät (5) des Messgerätes (2) gekoppelten Rechner (3, 38), der mittels einer bidirektionalen Kommunikation die Messelektronik (4) des Basisgerätes (5) für die Messung ansteuert und/oder mittels des Messgerätes ermittelte Messergebnisse ausliest.

13. Messsystem nach Anspruch 12, **dadurch gekennzeichnet, dass** der Rechner (3, 38) eingerichtet ist, mittels des Messgerätes (2) ermittelter Messwerte auf einer mit dem Rechner (3) verbundenen oder in den Rechner (3) integrierten Anzeigevorrichtung (14) visuell anzuzeigen.

14. Messsystem nach Anspruch 12 oder 13, **dadurch gekennzeichnet, dass** der Rechner als ein PC, ein PDA (38) oder ein Smartphone ausgeführt ist.

## Claims

1. Measuring device for verifying an electrical device, having a base unit (5), a housing (7), a socket (8) arranged on the housing (7) which is provided such that the electrical device is connected to the base unit (5) and supplied with electrical energy via said socket during the verification, a measurement electronics module (4) arranged within the housing (7) and an electronic interface (13) arranged on the housing (7) for connecting the base unit (5) to a computer (3, 38), as well as at least one functional module (6) able to be coupled to the base unit (5) for the modular expansion of the measuring device (2).

2. Measuring device according to claim 1, **characterised in that** the base unit (5) is embodied such that during the verification the computer (3, 38) is connected to the interface (13) of the base unit (5) in order to, by means of bidirectional communication, actuate the measurement electronics module (4) for the verification and/or read out measurement results determined by means of the measuring device.

3. Measuring device according to claim 2, **characterised in that** the base unit (5) is embodied without an integrated display device.

4. Measuring device according to one of claims 1 to 3, **characterised in that** the interface of the base unit (5) is embodied as a USB device interface (13).

5. Measuring device according to claim 4, **characterised by** a USB hub module (26) with a USB interface (39) for connecting the USB hub module (26) to the USB device interface (13) of the base unit, wherein the USB hub module (26) has at least two further USB interfaces (27), of which one is provided to be connected to the computer (3) during the bidirectional communication and the other is provided to be able to connect to the functional module (6).

6. Measuring device according to claim 5, **characterised in that** the functional module (6) can be supplied with electrical energy from the base unit (5) via the USB hub module (26).

7. Measuring device according to one of claims 1 to 6, **characterised in that** the functional module (6) can also be operated individually without being coupled to the base unit.

8. Measuring device according to one of claims 2 to 7, **characterised by** a transceiver module (35) which is able to be coupled to the interface (13) of the base unit (5) for wireless bidirectional communication between the computer and the base unit (5).

9. Measuring device according to claim 8, **characterised in that** the transceiver module (35) comprises a display for displaying measurement values determined with the measuring device (2).

10. Measuring device according to one of claims 1 to 9, **characterised in that** the socket (8) arranged on the housing (7) of the base unit (5) is fastened on the housing (7) in a detachable manner and can be replaced by a further socket which can be fastened on the housing (7) of the base unit (5) in a detachable manner.

11. Measuring device according to one of claims 1 to 10, **characterised in that** the base unit (5) comprises a terminal for connecting a leakage current clamp (22) and/or the base unit (5) comprises a terminal for applying a test voltage of preferably 500V DC to the device to be verified.

12. Measurement system, having a measuring device according to one of claims 2 to 11 and a computer (3, 38) coupled to the base unit (5) of the measuring device (2), which, by means of bidirectional communication, actuates the measurement electronics module (4) of the base unit (5) for the measurement and/or reads out measurement results determined by means of the measuring device.

13. Measurement system according to claim 12, **characterised in that** the computer (3, 38) is configured to visually display measurement values determined by means of the measuring device (2) on a display device (14) connected to the computer (3) or integrated into the computer (3).

14. Measurement system according to claim 12 or 13, **characterised in that** the computer is embodied as a PC, a PDA (38) or a smartphone.

## Revendications

1. Appareil de mesure pour la vérification d'un appareil électrique, comprenant un appareil de base (5), un boîtier (7), une prise (8) disposée sur le boîtier (7) prévue pour que par l'intermédiaire de celle-ci l'appareil électrique soit relié à l'appareil de base (5) durant la vérification et alimenté en énergie électrique, un équipement électronique de mesure (4) disposé à l'intérieur du boîtier (7) et une interface électronique (13) disposée sur le boîtier (7) pour relier l'appareil de base (5) à un ordinateur (3, 38), ainsi qu'au moins un module fonctionnel (6) pouvant être couplé à l'appareil de base (5) pour une extension modulaire de l'appareil de mesure (2).

2. Appareil de mesure selon la revendication 1, **caractérisé en ce que** l'appareil de base (5) est adapté pour que l'ordinateur (3, 38) soit relié à l'interface (13) de l'appareil de base (5) pendant la vérification, de manière à commander l'équipement électronique de mesure (4) au moyen d'une communication bidirectionnelle pour réaliser la vérification et/ou à extraire les résultats de mesure déterminés au moyen de l'appareil de mesure (2).

3. Appareil de mesure selon la revendication 2, **caractérisé en ce que** l'appareil de base (5) est réalisé sans dispositif d'affichage intégré.

4. Appareil de mesure selon l'une des revendications 1 à 3, **caractérisé en ce que** l'interface de l'appareil de base (5) est réalisée sous la forme d'une interface USB device (13).

5. Appareil de mesure selon la revendication 4, **caractérisé par** un module hub USB (26) ayant une interface USB (39) pour relier le module hub USB (26) à l'interface USB device (13) de l'appareil de base, le module hub USB (26) ayant au moins deux autres interfaces USB (27), dont l'une est prévue pour être reliée à l'ordinateur (3) pendant la communication bidirectionnelle et l'autre pour pouvoir être reliée au module fonctionnel (6).

6. Appareil de mesure selon la revendication 5, **caractérisé en ce que** le module fonctionnel (6) peut être alimenté en énergie électrique par l'appareil de base (5) à travers le module hub USB (26).

7. Appareil de mesure selon l'une des revendications 1 à 6, **caractérisé en ce que** le module fonctionnel (6) peut fonctionner individuellement sans être couplé à l'appareil de base.

8. Appareil de mesure selon l'une des revendications 2 à 7, **caractérisé par** un module d'émission-réception (35) couplé à l'interface (13) de l'appareil de base (5) pour une communication bidirectionnelle sans fil entre l'ordinateur et l'appareil de base (5).

9. Appareil de mesure selon la revendication 8, **caractérisé en ce que** le module d'émission-réception (35) comprend un afficheur pour afficher les valeurs de mesure déterminées au moyen de l'appareil de mesure (2).

10. Appareil de mesure selon l'une des revendications 1 à 9, **caractérisé en ce que** la prise (8) disposée sur le boîtier (7) de l'appareil de base (5) est fixée de manière amovible sur le boîtier (7) et peut être remplacée par une autre prise fixée de manière amovible sur le boîtier (7) de l'appareil de base (5).

11. Appareil de mesure selon l'une des revendications 1 à 10, **caractérisé en ce que** l'appareil de base (5) comprend une borne pour connecter une pince de mesure de courant de fuite (22) et/ou l'appareil de base (5) comprend une borne pour alimenter l'appareil à vérifier avec une tension d'essai de préférence égale à 500 V de tension continue.

12. Système de mesure, comprenant un appareil de mesure (2) selon l'une des revendications 2 à 11 et un ordinateur (3, 38) couplé à l'appareil de base (5) de l'appareil de mesure (2), ordinateur qui commande l'équipement électronique de mesure (4) de l'appareil de base (5) au moyen d'une communication bidirectionnelle pour réaliser la mesure et/ou extrait les résultats de mesure déterminés au moyen de l'appareil de mesure.

13. Système de mesure selon la revendication 12, **caractérisé en ce que** l'ordinateur (3, 38) est configuré pour faire apparaître visuellement, sur un dispositif d'affichage (14) relié à l'ordinateur (3) ou intégré dans l'ordinateur (3), les valeurs de mesure déterminées au moyen de l'appareil de mesure (2).

14. Système de mesure selon la revendication 12 ou 13, **caractérisé en ce que** l'ordinateur est réalisé sous la forme d'un PC, d'un PDA (38) ou d'un smartphone.
